# FASCICULE DE BREVET EUROPEEN

(11) **EP 4 264 683 B1**
(45) Date de publication et mention de la délivrance du brevet: **11.09.2024**
(21) Numéro de dépôt: 21839494.8
(22) Date de dépôt: 15.12.2021
(51) Int. Cl.: H01L 27/15, H01L 33/18, H01L 33/20, H01L 33/00, H01L 33/08

(54) **DISPOSITIF OPTOÉLECTRONIQUE À DIODES ÉLECTROLUMINESCENTES TRIDIMENSIONNELLES DE TYPE AXIAL ET SON PROCÉDÉ DE CONCEPTION**
OPTOELEKTRONISCHE VORRICHTUNG MIT DREIDIMENSIONALEN LICHTEMITTIERENDEN DIODEN VOM AXIALTYP UND VERFAHREN ZU IHRER GESTALTUNG
OPTOELECTRONIC DEVICE WITH AXIAL-TYPE THREE-DIMENSIONAL LIGHT-EMITTING DIODES AND PROCESS FOR ITS CONCEPTION

(30) Priorité: 17.12.2020 FR 2013518
(43) Date de publication de la demande: 25.10.2023
(73) Titulaire: Aledia, 38130 Echirolles (FR)
(72) Inventeur: DAANOUNE, Mehdi, 38140 RENAGE (FR); KRYLIOUK, Olga, FORT MYERS, Florida 33908 (US)
(74) Mandataire: Cabinet Beaumont
(86) Numéro de dépôt international: PCT/EP2021/086032
(87) Numéro de publication internationale: WO 2022/129252

(56) Documents cités:
- WO-A1-2006/134568
- FR-A1- 3 083 002
- US-A1- 2006 223 211
- CHRISTOPHER KÖLPER ET AL: "Towards nanorod LEDs: Numerical predictions and controlled growth", PHYSICA STATUS SOLIDI. C: CURRENT TOPICS IN SOLID STATE PHYSICS, vol. 8, no. 7-8, 20 April 2011 (2011-04-20), DE, pages 2305 - 2307, XP055558697, ISSN: 1862-6351, DOI: 10.1002/pssc.201000922
- C. J. LEWINS ET AL: "Strong photonic crystal behavior in regular arrays of core-shell and quantum disc InGaN/GaN nanorod light-emitting diodes", JOURNAL OF APPLIED PHYSICS, vol. 116, no. 4, 24 July 2014 (2014-07-24), US, pages 044305, XP055558770, ISSN: 0021-8979, DOI: 10.1063/1.4891236

## Description

La présente demande de brevet revendique la priorité de la demande de brevet français FR20/13518.

### Domaine technique

La présente invention concerne un dispositif optoélectronique, notamment un écran d'affichage ou un dispositif de projection d'images, comprenant des diodes électroluminescentes à base de matériaux semiconducteurs, et leurs procédés de fabrication.

### Technique antérieure

Pour certaines applications, il est recherché l'obtention de diodes électroluminescentes émettant un rayonnement électromagnétique à spectre étroit, idéalement sensiblement monochromatique et/ou des diodes électroluminescentes dont l'émission est la plus directive possible.

Un dispositif optoélectronique à diodes électroluminescentes tridimensionnelles de type axial peut présenter de telles propriétés. Une diode électroluminescente tridimensionnelle de type axial est une diode électroluminescente comprenant un élément semiconducteur tridimensionnel allongé s'étendant selon une direction privilégiée, par exemple un fil de diamètre micrométrique ou nanométrique, et comprenant une couche active à une extrémité axiale de l'élément semiconducteur tridimensionnel, la couche active étant la région de la diode électroluminescente depuis laquelle est émise la majorité du rayonnement électromagnétique fourni par la diode électroluminescente. La publication de C. Kölper *et al.* intitulée "Towards nanorods LEDs: Numerical prédictions and controlled growth" (Physica Status Solidi C: Current Topics In Solid State Physics, vol. 8, N° 7-8, 20 avril 2011, pages 2305-2307), la publication de C.J. Lewins et al. intitulée "Strong photonic crystal behavior in regular arrays of core-shell and quantum dise InGaN/GaN nanorod light-emitting diodes" (Journal of Applied Physics, vol. 116, n° 4, 24 juillet 2014, pages 044305-1 à 044305-7), et les documents FR 3 083 002 A1, WO 2006/134568 A1 et US 2006/223211 A1 décrivent chacun un dispositif optoélectronique à matrice de diodes électroluminescentes tridimensionnelles.

Toutefois, pour certaines applications dans lesquelles il est recherché un dispositif optoélectronique émettant un rayonnement à spectre très étroit et/ou très directif, les diodes électroluminescentes tridimensionnelles de type axial connues peuvent ne pas donner satisfaction. Résumé de l'invention

Ainsi, un objet d'un mode de réalisation est de pallier au moins en partie les inconvénients des dispositifs optoélectroniques à diodes électroluminescentes décrits précédemment.

Un autre objet d'un mode de réalisation est que les diodes électroluminescentes tridimensionnelles de type axial aient un spectre d'émission étroit.

Un autre objet d'un mode de réalisation est que les diodes électroluminescentes tridimensionnelles de type axial émettent un rayonnement directif.

Un dispositif optoélectronique selon la présente invention comprend, conformément à la revendication 1 en annexe: une matrice de diodes électroluminescentes axiales, chaque diode électroluminescente comprenant une couche active configurée pour émettre un rayonnement électromagnétique, la matrice formant un cristal photonique configuré pour former, dans un plan contenant les couches actives, au moins des premiers et deuxièmes pics de résonance, chaque premier pic de résonance amplifiant l'intensité dudit rayonnement électromagnétique à une première longueur d'onde, chaque deuxième pic de résonance amplifiant l'intensité dudit rayonnement électromagnétique à une deuxième longueur d'onde, dans lequel chaque diode électroluminescente comprend un élément semiconducteur allongé selon un axe, ayant une première portion ayant un premier diamètre moyen, une deuxième portion prolongeant la première portion et ayant une section droite diminuant en s'éloignant de la première portion, et la couche active prolongeant la deuxième portion et ayant un deuxième diamètre moyen inférieur strictement au premier diamètre moyen, les couches actives étant situées aux emplacements des premiers pics de résonance et absentes aux emplacements des deuxièmes pics de résonance.

D'autres modes avantageux de réalisation de la présente invention sont l'objet des revendications dépendantes en annexe.

Selon un mode de réalisation, le double du rapport entre le deuxième diamètre moyen et le premier diamètre moyen est compris entre 0,5 et 1,8.

Selon un mode de réalisation, le double du rapport entre le deuxième diamètre moyen et le premier diamètre moyen est compris entre 0,6 et 1,4.

Selon un mode de réalisation, le premier diamètre moyen est compris entre µm et 2 µm.

Selon un mode de réalisation, le premier diamètre moyen est compris entre 100 nm et 1 µm.

Selon un mode de réalisation, la hauteur, mesurée selon ledit axe, de la deuxième portion est inférieure à 10 % de la hauteur, mesurée selon ledit axe de l'élément semiconducteur allongé.

Selon un mode de réalisation, la première portion de l'élément semiconducteur allongé a une section droite constante.

Selon un mode de réalisation, les diodes électroluminescentes axiales sont agencées en réseau avec un pas compris entre 0,1 µm et 4 µm.

Selon un mode de réalisation, la hauteur de chaque élément semiconducteur allongé, mesurée selon ledit axe, est comprise entre 100 nm et 50 µm.

Selon la présente invention, un procédé de conception du dispositif optoélectronique tel que défini précédemment, comprend également, conformément à la revendication 10 en annexe, les étapes suivantes :
a) déterminer par simulation le pas du cristal photonique et le premier diamètre moyen en considérant que les éléments semiconducteurs allongés sont à section droite constante ;
b) diminuer le deuxième diamètre moyen sans modifier le premier diamètre moyen ;
c) simuler le fonctionnement du dispositif optoélectronique avec les couches actives ayant le deuxième diamètre moyen diminué ; et
d) répéter les étapes b) et c) jusqu'à ce que les couches actives soient situées aux emplacements des premiers pics de résonance et absentes aux emplacements des deuxièmes pics de résonance.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et schématique, d'un mode de réalisation d'un dispositif optoélectronique selon la présente invention comprenant des diodes électroluminescentes ;
la figure 2 est une vue en perspective, partielle et schématique, du dispositif optoélectronique selon l'invention représenté en figure 1 ;
la figure 3 est une vue en coupe, partielle et schématique, correspondant à une vue de détail d'une partie du dispositif optoélectronique selon l'invention représenté en figure 1 ;
la figure 4 est une vue en coupe, partielle et schématique, d'un dispositif optoélectronique de comparaison, ne faisant pas partie de la présente invention telle que revendiquée mais utile pour en comprendre le contexte, utilisé pour une première simulation ;
la figure 5 est une carte en niveaux de gris de l'intensité lumineuse émise par le dispositif optoélectronique de comparaison en fonction de la longueur d'onde du rayonnement émis et de l'angle d'émission illustrant la présence de deux modes d'émission ;
la figure 6 représente des courbes d'évolution du flux cumulé respectivement du rayonnement émis par le dispositif optoélectronique de comparaison et un rayonnement lambertien ;
la figure 7 représente un diagramme de rayonnement pour le rayonnement émis par le dispositif optoélectronique de comparaison et pour un rayonnement lambertien ;
la figure 8 est une carte en niveaux de gris d'un facteur d'amplification du premier mode pour le dispositif optoélectronique de comparaison dans un plan contenant les couches actives des diodes électroluminescentes ;
la figure 9 est une carte en niveaux de gris d'un facteur d'amplification du deuxième mode pour le dispositif optoélectronique de comparaison dans un plan contenant les couches actives des diodes électroluminescentes ;
la figure 10 est une vue en coupe schématique d'une partie d'une diode électroluminescente du dispositif optoélectronique selon l'invention de la figure 1 avec les régions de forte amplification illustrées sur les figures 8 et 9 ;
la figure 11 est une vue de dessus schématique d'une partie d'une diode électroluminescente du dispositif optoélectronique selon l'invention de la figure 1 avec les régions de forte amplification illustrées sur les figures 8 et 9 ;
la figure 12 est une carte en niveaux de gris, obtenue par simulation, de l'intensité lumineuse émise par le dispositif optoélectronique selon l'invention de la figure 1 en fonction de la longueur d'onde du rayonnement émis et de l'angle d'émission pour un premier facteur d'amincissement des diodes électroluminescentes ;
la figure 13 est analogue à la figure 12 pour un deuxième facteur d'amincissement des diodes électroluminescentes ;
la figure 14 est analogue à la figure 6 pour le dispositif optoélectronique selon l'invention de la figure 1 avec le deuxième facteur d'amincissement ;
la figure 15 est analogue à la figure 7 pour le dispositif optoélectronique selon l'invention de la figure 1 avec le deuxième facteur d'amincissement ;
la figure 16 est une carte en niveaux de gris, obtenue lors d'un premier essai, de l'intensité lumineuse émise par le dispositif optoélectronique de comparaison en fonction de la longueur d'onde du rayonnement émis et de l'angle d'émission ;
la figure 17 représente une courbe d'évolution, obtenue lors du premier essai, de l'intensité lumineuse émise par le dispositif optoélectronique de comparaison orthogonalement à la face d'émission en fonction de la longueur d'onde du rayonnement émis ;
la figure 18 est une carte en niveaux de gris, obtenue lors d'un deuxième essai, de l'intensité lumineuse émise par le dispositif optoélectronique selon l'invention de la figure 1 en fonction de la longueur d'onde du rayonnement émis et de l'angle d'émission ;
la figure 19 représente une courbe d'évolution, obtenue lors d'un troisième essai, de l'intensité lumineuse émise par le dispositif optoélectronique selon l'invention de la figure 1 orthogonalement à la face d'émission en fonction de la longueur d'onde du rayonnement émis ;
la figure 20 est une carte en niveaux de gris, obtenue par simulation, de l'intensité lumineuse émise par le dispositif optoélectronique selon l'invention de la figure 1 en fonction de la longueur d'onde du rayonnement émis et du rapport d'amincissement ; et
la figure 21 est un schéma par blocs d'un mode de réalisation d'un procédé de conception selon la présente invention du dispositif optoélectronique également selon l'invention de la figure 1.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques. Par souci de clarté, seuls les étapes et éléments utiles à la compréhension des modes de réalisation décrits ont été représentés et sont détaillés. En particulier, les dispositifs optoélectroniques considérés comprennent éventuellement d'autres composants qui ne seront pas détaillés.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un dispositif optoélectronique dans une position normale d'utilisation.

Sauf précision contraire, les expressions "environ", "approximativement", "sensiblement", et "de l'ordre de" signifient à 10 % près, de préférence à 5 % près. En outre, on considère ici que les termes "isolant" et "conducteur" signifient respectivement "isolant électriquement" et "conducteur électriquement".

Dans la suite de la description, la transmittance interne d'une couche correspond au rapport entre l'intensité du rayonnement sortant de la couche et l'intensité du rayonnement entrant dans la couche. L'absorption de la couche est égale à la différence entre 1 et la transmittance interne. Dans la suite de la description, une couche est dite transparente à un rayonnement lorsque l'absorption du rayonnement au travers de la couche est inférieure à 60 %. Dans la suite de la description, une couche est dite absorbante à un rayonnement lorsque l'absorption du rayonnement dans la couche est supérieure à 60 %. Lorsqu'un rayonnement présente un spectre de forme générale "en cloche", par exemple de forme gaussienne, ayant un maximum, on appelle longueur d'onde du rayonnement, ou longueur d'onde centrale ou principale du rayonnement, la longueur d'onde à laquelle le maximum du spectre est atteint. Dans la suite de la description, l'indice de réfraction d'un matériau correspond à l'indice de réfraction du matériau pour la plage de longueurs d'onde du rayonnement émis par le dispositif optoélectronique. Sauf indication contraire, l'indice de réfraction est considéré sensiblement constant sur la plage de longueurs d'onde du rayonnement utile, par exemple égal à la moyenne de l'indice de réfraction sur la plage de longueurs d'onde du rayonnement émis par le dispositif optoélectronique.

Par diode électroluminescente axiale, on désigne une structure tridimensionnelle de forme allongée, par exemple cylindrique, selon une direction privilégiée, dont au moins deux dimensions, appelées dimensions mineures, sont comprises entre 5 nm et 2,5 µm, de préférence entre 50 nm et 2,5 µm. La troisième dimension, appelée dimension majeure, est supérieure ou égale à 1 fois, de préférence supérieure ou égale à 5 fois et encore plus préférentiellement supérieure ou égale à 10 fois, la plus grande des dimensions mineures. Dans certains modes de réalisation, les dimensions mineures peuvent être inférieures ou égales à environ 1 µm, de préférence comprises entre 100 nm et 1 µm, plus préférentiellement entre 100 nm et 800 nm. Dans certains modes de réalisation, la hauteur de chaque diode électroluminescente peut être supérieure ou égale à 500 nm, de préférence comprise entre 1 µm et 50 µm.

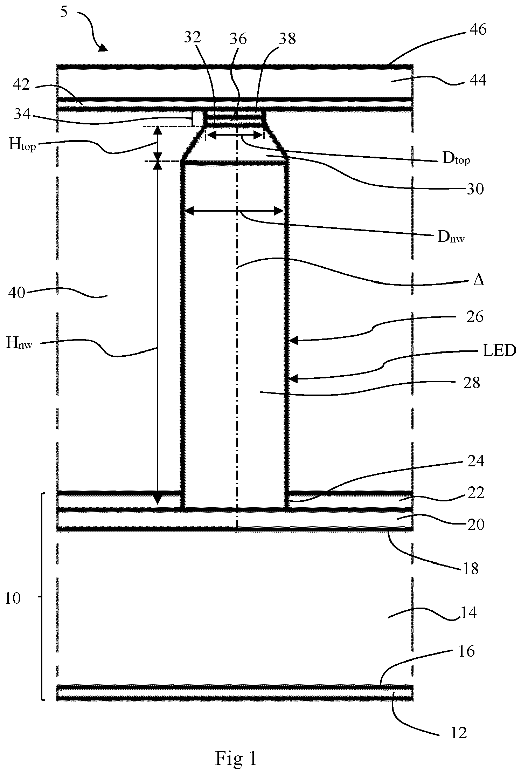

La figure 1 est une vue en coupe latérale, partielle et schématique, d'un mode de réalisation d'un dispositif optoélectronique 5 à diodes électroluminescentes selon la présente invention dans lequel les éléments semiconducteurs correspondent à des nanofils ou des microfils qui permet d'obtenir l'émission d'un rayonnement à spectre étroit et/ou directif.

Le dispositif 5 selon l'invention comprend :
- un support 10, comprenant par exemple une première électrode 12, un substrat 14, par exemple semiconducteur, comprenant des faces parallèles 16 et 18, la face 16 étant au contact de l'électrode 12, une couche de nucléation 20 recouvrant la face 18, et une couche isolante 22 recouvrant la couche de nucléation 20 et comprenant des ouvertures 24 aux emplacements souhaités des fils, une seule ouverture 24 étant représentée en figure 1 ;
- une matrice de diodes électroluminescentes LED reposant sur le support 10, une seule diode électroluminescente LED étant représentée en figure 1, chaque diode électroluminescente LED comprenant un fil 26 en contact avec la couche de nucléation 20 dans l'une des ouvertures 24, le fil 26 étant au moins en partie dopé d'un premier type de conductivité, par exemple dopé de type N, et comprenant une portion inférieure 28 sensiblement cylindrique, au contact de la couche de nucléation 20, et se prolongeant par une portion supérieure 30 dont la section droite diminue en s'éloignant du substrat 14, la portion supérieure 30 ayant une face sommitale 32, chaque diode électroluminescente LED comprenant en outre une coque 34 recouvrant la face sommitale 32 du fil 26, la coque 34 comprenant une couche active 36 et une couche semiconductrice 38 dopée d'un second type de conductivité, par exemple dopée de type P ;
- une couche isolante 40 recouvrant la périphérie de chaque fil 26 et de chaque coque 34 et transparente au rayonnement émis par la couche active 36 ;
- une couche 42 conductrice électriquement et transparente au rayonnement émis par la couche active 36, recouvrant la couche isolante 40 et chaque coque 34, et au contact de chaque coque 34, la couche conductrice 42 formant la seconde électrode ; et
- une couche d'encapsulation 44 isolante électriquement et transparente au rayonnement émis par la couche active 36 et recouvrant l'ensemble de la structure, la couche d'encapsulation 44 ayant une face supérieure 46 appelée face d'émission.

La couche active 36 est la couche depuis laquelle est émise la majorité du rayonnement électromagnétique fourni par la diode électroluminescente LED. Les diodes électroluminescentes LED peuvent être connectées en parallèle et former un ensemble de diodes électroluminescentes. L'ensemble peut comprendre de quelques diodes électroluminescentes LED à un millier de diodes électroluminescentes.

Chaque diode électroluminescente LED est dite axiale dans la mesure où la couche active 36 est dans le prolongement du fil 26 et la couche semiconductrice 38 est dans le prolongement de la zone active 20, l'ensemble comprenant le fil 26, la couche active 36, et la couche semiconductrice 38 s'étendant selon un axe Δ, appelé axe du fil 26 ou axe de la diode électroluminescente axiale. De préférence, les axes Δ des diodes électroluminescentes LED sont parallèles et orthogonaux à la face 18.

La base du fil 26 a, par exemple, une forme ovale, circulaire ou polygonale, notamment triangulaire, rectangulaire, carrée ou hexagonale. La section droite du fil peut être constante le long de l'axe Δ du fil ou peut varier le long de l'axe du fil. On appelle D_{nw} le diamètre moyen de la portion inférieure 28 du fil 26. Dans le cas d'un fil 26 dont la portion inférieure 28 a une section droite de forme circulaire, le diamètre moyen correspond au diamètre du cercle. Dans le cas d'un fil 26 dont la portion inférieure 28 a une section droite différente d'un cercle, le diamètre moyen correspond au diamètre du cercle délimitant la même aire que l'aire de la section droite de la portion inférieure 28. On appelle en outre Dₜₒₚ le diamètre moyen de la face sommitale 32. De préférence, la face sommitale 32 est plane. De préférence, la face sommitale 32 correspond à un plan cristallin perpendiculaire à la direction de croissance c du cristal composant le fil 26. Dans le cas où la face sommitale 32 correspond à un cercle, le diamètre moyen Dₜₒₚ correspond au diamètre du cercle. Dans le cas où la face sommitale 32 est différente d'un cercle, le diamètre moyen Dₜₒₚ correspond au diamètre du cercle délimitant la même aire que l'aire de la section droite de la face sommitale 32. On appelle rapport d'amincissement SF le double du rapport entre le diamètre Dₜₒₚ et le diamètre D_{nw}. De plus, on appelle H_{nw} la hauteur, mesurée selon l'axe Δ, de la portion inférieure 28 du fil 26 et Hₜₒₚ la hauteur, mesurée selon l'axe, de la portion supérieure 30 du fil 26.

Le diamètre D_{nw} peut être compris entre 0,05 µm et 2 µm, de préférence entre 100 nm et 1 µm, plus préférentiellement entre 100 nm et 800 nm. Selon un mode de réalisation, le rapport d'amincissement SF est inférieur à 1,8, de préférence inférieur à 1,6, plus préférentiellement inférieur à 1,4, encore plus préférentiellement inférieur à 1,2. Selon un mode de réalisation, le rapport d'amincissement SF est supérieur à 0,5, de préférence supérieur à 0,7, plus préférentiellement supérieur à 0,8.

Selon un mode de réalisation, la hauteur du fil 26, qui correspond à la somme des hauteurs H_{nw} et Hₜₒₚ, peut être supérieure ou égale à 100 nm, de préférence comprise entre 500 nm et 50 µm, plus préférentiellement comprise entre 1 µm et 50 µm. La hauteur Hₜₒₚ est inférieure à 10 %, de préférence 8 %, plus préférentiellement 5 %, de la hauteur du fil 26.

Selon un mode de réalisation, dans le cas où la section droite de la portion inférieure 28 du fil 26 n'est pas constante le long de l'axe Δ, la portion inférieure 28 est définie comme la portion du fil 26 depuis la base au contact du support 10 pour laquelle les variations du diamètre moyen de la section droite restent inférieures à 10 %. Le diamètre moyen D_{nw} de la portion inférieure 28 du fil 26 peut alors correspondre au diamètre moyen de la section droite de la portion inférieure 28 à la jonction entre la portion inférieure 28 et la portion supérieure 30 ou peut correspondre à la moyenne des diamètres moyens des sections droites de la portion inférieure 28 du fil 26 le long de l'axe Δ.

Dans le mode de réalisation illustrée en figure 1, la portion supérieure 30 a une forme tronconique. A titre de variante, la portion supérieure 30 peut avoir une forme évasée, concave ou convexe.

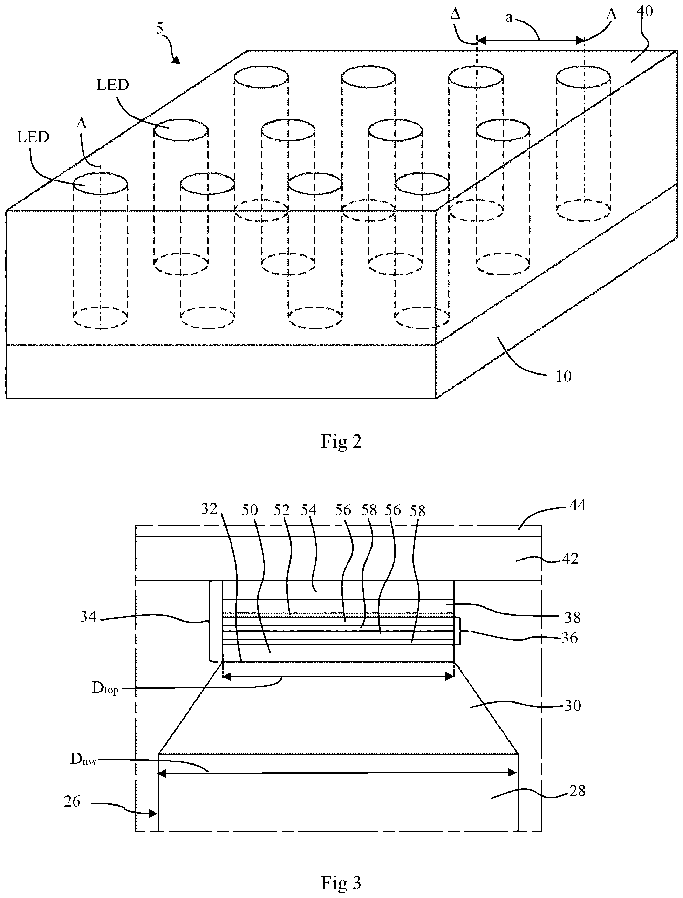

La figure 2 est une vue en perspective, partielle et schématique, du dispositif optoélectronique 5. En figure 2, chaque diode électroluminescente LED est représentée de façon schématique par un cylindre. En outre, les couches 42 et 44 ne sont pas représentées.

Selon la présente invention, les diodes électroluminescentes LED sont agencées pour former un cristal photonique. Douze diodes électroluminescentes LED sont représentées à titre d'exemple en figure 2. En pratique, la matrice de diodes électroluminescentes LED peut comprendre entre 7 et 100000 diodes électroluminescentes LED.

Selon un mode de réalisation, les diodes électroluminescentes LED sont agencées en lignes et en colonnes (3 lignes et 4 colonnes étant représentées à titre d'exemple en figure 2). Le pas 'a' de la matrice est la distance entre l'axe d'une diode électroluminescente LED et l'axe Δ d'une diode électroluminescente LED proche, de la même ligne ou d'une ligne adjacente. Le pas a est sensiblement constant. Selon un mode de réalisation, le pas a peut être compris entre 0,1 µm et 4 µm.

Plus précisément, le pas a de la matrice est choisi de telle manière que la matrice forme un cristal photonique. Le cristal photonique formé est par exemple un cristal photonique 2D. Dans l'exemple d'agencement illustré en figure 2, appelé agencement en carré, une diode électroluminescente LED est située à chaque croisement d'une ligne et d'une colonne, les lignes étant perpendiculaires aux colonnes. Selon un autre exemple d'agencement, appelé agencement hexagonal, les diodes électroluminescentes sur une ligne sont décalées de la moitié du pas a par rapport aux diodes électroluminescentes sur la ligne précédente et la ligne suivante.

Les propriétés du cristal photonique formé par la matrice sont choisies avantageusement pour que la matrice des diodes électroluminescentes forme une cavité résonante dans le plan perpendiculaire à l'axe Δ et une cavité résonnante selon l'axe Δ notamment pour obtenir un couplage et augmenter l'effet de sélection. Ceci permet que l'intensité du rayonnement émis par l'ensemble des diodes électroluminescentes LED de la matrice par la face d'émission 46 soit amplifiée pour certaines longueurs d'onde par rapport à un ensemble de diodes électroluminescentes LED qui ne formerait pas un cristal photonique. Il est à noter que les pics de résonance du cristal photonique peuvent être différents de la longueur d'onde pour laquelle le spectre d'émission de la couche active 26, pris isolément, est maximum. De façon avantageuse, l'un des pics de résonance du cristal photonique est identique ou proche de la longueur d'onde pour laquelle le spectre d'émission de la couche active 26, pris isolément, est maximum.

Les propriétés du cristal photonique sont fixées par les dimensions géométriques des éléments composant le dispositif optoélectronique 5 et des matériaux composant ces éléments. En première approximation, les propriétés du cristal photonique peuvent être fixées par les fils 26.

Selon un mode de réalisation, les fils 26 et les coques 34 sont, au moins en partie, en un matériau semiconducteur. Le matériau semiconducteur est choisi parmi le groupe comprenant les composés III-V, les composés II-VI, et les semiconducteurs ou composés du groupe IV. Des exemples d'éléments du groupe III comprennent le gallium (Ga), l'indium (In) ou l'aluminium (Al). Des exemples d'éléments du groupe IV comprennent l'azote (N), le phosphore (P) ou l'arsenic (As). Des exemples de composés III-N sont GaN, AlN, InN, InGaN, AlGaN ou AlInGaN. Des exemples d'éléments du groupe II comprennent des éléments du groupe IIA, notamment le béryllium (Be) et le magnésium (Mg) et des éléments du groupe IIB, notamment le zinc (Zn), le cadmium (Cd) et le mercure (Hg). Des exemples d'éléments du groupe VI comprennent des éléments du groupe VIA, notamment l'oxygène (O) et le tellure (Te). Des exemples de composés II-VI sont ZnO, ZnMgO, CdZnO, CdZnMgO, CdHgTe, CdTe ou HgTe. De façon générale, les éléments dans le composé III-V ou II-VI peuvent être combinés avec différentes fractions molaires. Des exemples de matériaux semiconducteurs du groupe IV sont le silicium (Si), le carbone (C), le germanium (Ge), les alliages de carbure de silicium (SiC), les alliages silicium-germanium (SiGe) ou les alliages de carbure de germanium (GeC). Les fils 26 et les couches semiconductrices 38 peuvent comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du soufre (S), du terbium (Tb) ou de l'étain (Sn). De préférence, la couche semiconductrice 38 est en GaN dopé P et le fil 26 est au moins en partie en GaN dopé N.

La deuxième couche d'électrode 42 est conductrice et transparente. Selon un mode de réalisation, la couche d'électrode 42 est une couche d'oxyde transparent et conducteur (TCO), tel que de l'oxyde d'indium-étain (ou ITO, sigle anglais pour Indium Tin Oxide), de l'oxyde de zinc dopé ou non à l'aluminium ou au gallium, ou du graphène. A titre d'exemple, la couche d'électrode 42 a une épaisseur comprise entre 5 nm et 200 nm, de préférence entre 20 nm et 50 nm. La couche isolante 22 ou 40 ou le revêtement 44 peuvent être en un matériau inorganique, par exemple en oxyde de silicium ou en nitrure de silicium. La couche isolante 40 et/ou le revêtement 44 peuvent être en un matériau organique, par exemple un polymère isolant à base de benzocyclobutène (BCB). Le revêtement 44 peut comprendre un filtre optique, ou des filtres optiques disposés les uns à côté des autres, comme cela sera décrit plus en détail par la suite.

La couche de germination 20 est en un matériau favorisant la croissance des fils 26. A titre d'exemple, le matériau composant la couche de germination 20 peut être un nitrure, un carbure ou un borure d'un métal de transition de la colonne IV, V ou VI du tableau périodique des éléments ou une combinaison de ces composés. La couche de germination 20 peut être remplacée par des plots de germination distincts, chaque fil 26 reposant sur un plot de germination.

Le support 10 peut avoir une structure différente de celle décrite précédemment. Selon un mode de réalisation, le support 10 peut correspondre à un circuit électronique ayant en surface une couche d'électrode sur laquelle reposent les diodes électroluminescentes. La couche d'électrode 12 peut être divisée en parties distinctes de façon permettre la commande séparée de groupes de diodes électroluminescentes de la matrice de diodes électroluminescentes.

La figure 3 est une vue agrandie de la coque 34. La coque 34 peut comprendre un empilement de plusieurs couches semiconductrices comprenant notamment :
- une couche intercalaire 50, par exemple en GaN, recouvrant la face sommitale 32 de la portion supérieure 30 du fil 26 ;
- la couche active 36 recouvrant la couche intercalaire 50, de préférence au contact de la couche intercalaire 50 ;
- éventuellement, une couche barrière 52 recouvrant la couche active 36 ;
- la couche semiconductrice 38 de type de conductivité opposé à la portion inférieure 28 du fil 26 recouvrant la couche barrière 52 ; et
- une couche de liaison 54 recouvrant la couche semiconductrice 38, recouverte par la couche d'électrode 42 et au contact de la couche d'électrode 42.

La couche intercalaire 50 est, de préférence, une couche du même matériau semiconducteur que la portion supérieure 28 du fil 26 ou d'un alliage de type GaInN ou AlGaN ou AlGaInN. La couche intercalaire 50 est prévue pour fournir une surface ayant des propriétés convenables pour la croissance de la couche active 36. L'épaisseur de la couche intercalaire 50 peut être de l'ordre de 5 nm à 5 µm, de préférence de 10 nm à 2000 nm.

La couche active 36 peut comporter des moyens de confinement tels que des puits quantiques multiples. Elle est, par exemple, constituée d'une alternance de couches de GaN 56 et de InGaN 58, deux couches 56 de GaN et deux couches 58 de InGaN étant représentées à titre d'exemple en figure 3. Les couches 56 de GaN peuvent être dopées, par exemple de type N ou P, ou non dopées. Selon un autre exemple, la couche active 36 peut comprendre un puits quantique unique comprenant une seule couche d'InGaN, par exemple d'épaisseur supérieure à 10 nm entre deux couches de GaN.

Le procédé de croissance des diodes électroluminescentes LED peut être un procédé du type ou une combinaison de procédés du type dépôt chimique en phase vapeur (CVD, sigle anglais pour Chemical Vapor Deposition), dépôt chimique en phase vapeur aux organométalliques (MOCVD, acronyme anglais pour Metal-Organic Chemical Vapor Déposition), également connu sous le nom d'épitaxie organométallique en phase vapeur (MOVPE, acronyme anglais pour Metal-Organic Vapor Phase Epitaxy), ou dépôt chimique en phase vapeur aux organométalliques à assistance au plasma indirecte (RP-MOCVD, acronyme anglais pour Remote Plasma Metal-Organic Chemical Vapor Déposition). Toutefois, des procédés tels que l'épitaxie par jets moléculaires (MBE, acronyme anglais pour Molecular-Beam Epitaxy), la MBE à source de gaz (GSMBE), la MBE organométallique (MOMBE), la MBE assistée par plasma (PAMBE), l'épitaxie par couche atomique (ALE, acronyme anglais pour Atomic Layer Epitaxy) ou l'épitaxie en phase vapeur aux hydrures (HVPE, acronyme anglais pour Hydride Vapor Phase Epitaxy) peuvent être utilisés. Toutefois, des procédés électrochimiques peuvent être utilisés, par exemple, le dépôt en bain chimique (CBD, sigle anglais pour Chemical Bath Déposition), les procédés hydrothermiques, la pyrolise d'aérosol liquide ou l'électrodépôt.

La formation des portions supérieures 30 des fils 26 peut être obtenue en faisant varier des conditions de croissance des fils 26 entre des conditions initiales de croissance permettant l'obtention de fils de diamètre D_{nw} et des conditions de croissance finales permettant l'obtention de fils de diamètre Dₜₒₚ, par exemple en augmentant de façon progressive le rapport V/III et en abaissant la température pour obtenir une diminution du diamètre.

Selon un mode de réalisation, les portions inférieures 28 des fils sont formées par MOCVD et les portions supérieures 30 des fils 26 sont formées par MBE.

Des simulations et des essais ont été réalisés. Pour ces simulations et ces essais, pour chaque diode électroluminescente LED, la portion inférieure 28 et la portion supérieure 30 sont en GaN dopé de type N. L'indice de réfraction des portions inférieure et supérieure 28 et 30 est compris entre 2,4 et 2,5. La couche active 36 correspond à une couche de InGaN. La couche semiconductrice 38 est en GaN dopé de type P. La couche d'électrode 42 est en TCO. La couche isolante 40 et la couche d'encapsulation 44 sont en polymère à base de BCB. L'indice de réfraction de la couche isolante 40 est compris entre 1,45 et 1,56. On a considéré un réseau de diodes électroluminescentes LED répartis selon un maillage hexagonal. La hauteur du fil 26 est comprise entre 300 nm et 1 µm. La hauteur de la portion supérieure 30 est comprise entre 20 nm et 300 nm. L'épaisseur de la coque 34 est comprise entre 100 nm et 500 nm. L'épaisseur de la couche d'électrode 42 est comprise entre 100 nm et 500 nm. L'épaisseur de la couche d'encapsulation 44 est comprise entre 1 µm et 1 mm.

Pour la première simulation, le rapport d'amincissement SF d'un dispositif optoélectronique 5' de comparaison, ne faisant pas partie de la présente invention telle que revendiquée mais étant utile pour en comprendre le contexte, est égal à 2.

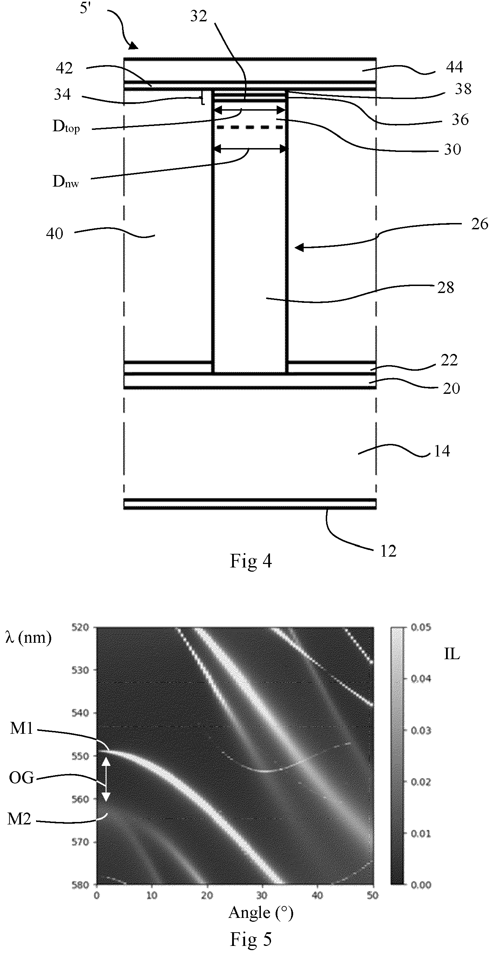

La figure 4 est une vue en coupe, partielle et schématique, du dispositif optoélectronique 5' lorsque le rapport d'amincissement SF est égal à 2. La section droite de la portion supérieure 30 est sensiblement constante et identique à la section droite de la portion inférieure 28 du fil 26. Le dispositif optoélectronique 5' selon cette configuration est appelé dispositif optoélectronique de comparaison.

La figure 5 est une carte en niveaux de gris de l'intensité lumineuse IL, en unité arbitraire, du rayonnement émis par la face d'émission 46 du dispositif optoélectronique de comparaison en fonction de la longueur d'onde X du rayonnement émis et de l'angle d'émission par rapport à une direction orthogonale à la face d'émission 46. Les zones claires de la carte de niveaux de gris correspondent à des pics de résonance. Pour de faibles angles d'émission, on observe notamment un premier mode d'émission M1 à des longueurs d'onde voisines de 550 nm et un deuxième mode d'émission M2 à des longueurs d'onde supérieures. L'écart optique OG correspond à l'écart entre les longueurs d'onde des modes M1 et M2 pour un angle d'émission donné.

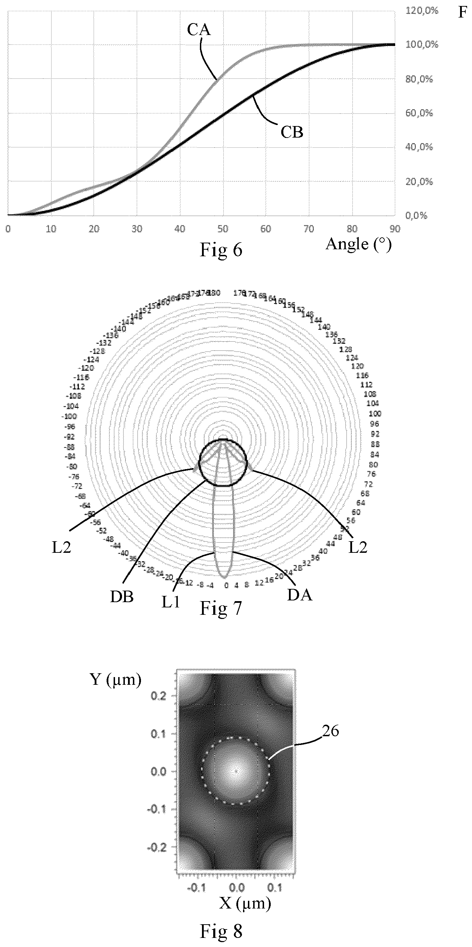

La figure 6 représente une courbe CA d'évolution du flux cumulé F, exprimé en pourcentage, du rayonnement émis par le dispositif optoélectronique de comparaison dans un cône d'axe perpendiculaire à la face d'émission 46 en fonction du demi-angle au sommet du cône. La courbe CB correspond à la courbe d'évolution du flux cumulé pour un rayonnement lambertien.

La figure 7 représente un diagramme de rayonnement pour le dispositif optoélectronique de comparaison (courbe DA) et pour un rayonnement lambertien (DB). Le diagramme de rayonnement DA présente un lobe principal L1, centré sensiblement sur 0 ° et des lobes secondaires L2 centrés sensiblement sur +/- 45 °.

Le premier mode M1 correspond à un pic d'intensité d'émission centré à la fréquence principale et participe essentiellement à la formation du lobe L1 dans le diagramme de rayonnement. Le mode M2 est à l'origine d'un étalement du spectre d'émission de la diode électroluminescente LED ainsi que de la formation des lobes secondaires L2. Comme cela apparaît sur les figures 6 et 7, une part importante de l'énergie du rayonnement du dispositif optoélectronique de comparaison est perdue dans les lobes secondaires L2. En particulier, moins de 20 % du flux est émis dans le cône de demi-angle au sommet égal à 20 °.

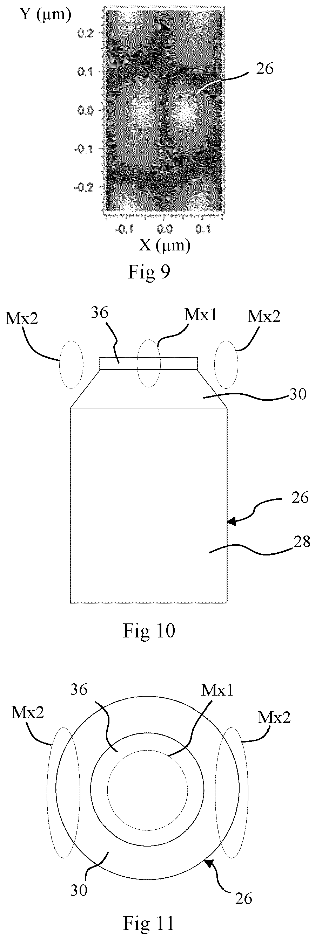

Les figures 8 et 9 sont des cartes en niveaux de gris du facteur d'amplification dû au cristal photonique respectivement pour le premier mode et le deuxième mode dans un plan parallèle à la face d'émission 42 et contenant les couches actives 36. Les zones claires correspondent à des zones où le facteur d'amplification est plus important. On a représenté en traits blancs pointillés le contour du fil 26 d'une diode électroluminescente. En premier approximation, les figures 8 et 9 ne dépendent sensiblement pas des dimensions latérales de la couche active 36.

Les inventeurs ont mis en évidence qu'il était possible de réduire la contribution du deuxième mode M2 par rapport au mode M1 dans le rayonnement émis par le dispositif optoélectronique 5 en modifiant les dimensions latérales de la couche active 36, sans modifier le diamètre moyen D_{nw} de la portion inférieure 28 du fil 26, de façon que la couche active 36 soit située à un emplacement où le facteur d'amplification du mode M1 est important et où le facteur d'amplification du mode M2 est faible. De ce fait, le cristal photonique amplifie essentiellement seulement la génération de photons selon le premier mode M1.

Les figures 10 et 11 sont respectivement une vue en coupe latérale et une vue de dessus, partielles et schématiques, d'une partie du fil 26 et de la couche active 36 du dispositif optoélectronique 5 selon la présente invention de la figure 1 sur lesquelles on a ajouté des zones Mx1 symbolisant chacune une zone où le facteur d'amplification du premier mode M1 dû au cristal photonique est élevé et des zones Mx2 symbolisant chacune une zone où le facteur d'amplification du deuxième mode M2 dû au cristal photonique est élevé. Comme cela apparaît sur les figures 10 et 11, par la sélection du rapport d'amincissement SF, la couche active 36 peut être disposée de façon à ne pas être présente au niveau des zones Mx2.

Une deuxième simulation a été réalisée. Pour la deuxième simulation, le rapport d'amincissement SF est égal à 1,6.

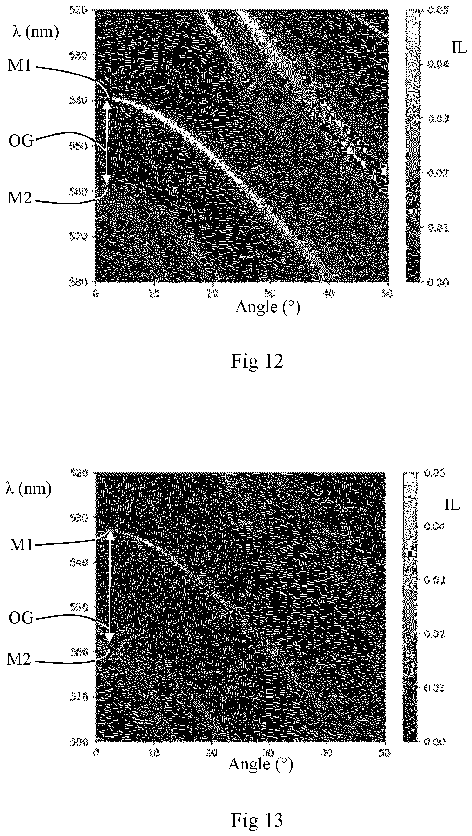

La figure 12 est une carte en niveaux de gris de l'intensité lumineuse IL du rayonnement émis par la face d'émission 46 du dispositif optoélectronique 5 selon un mode de réalisation de la présente invention lors de la deuxième simulation en fonction de la longueur d'onde λ du rayonnement émis et de l'angle d'émission par rapport à une direction orthogonale à la face d'émission 46. Par rapport à la première simulation, on observe un décalage du premier mode M1 vers les plus petites longueurs d'onde (décalage vers le bleu). L'écart optique OG est ainsi augmenté. On observe en outre une atténuation du deuxième mode M2.

Une troisième simulation a été réalisée. Pour la troisième simulation, le rapport d'amincissement est égal à 1,2.

La figure 13 est une carte en niveaux de gris de l'intensité lumineuse IL du rayonnement émis par la face d'émission 46 du dispositif optoélectronique 5 selon un autre mode de réalisation de la présente invention lors de la troisième simulation en fonction de la longueur d'onde λ du rayonnement émis et de l'angle d'émission par rapport à une direction orthogonale à la face d'émission 46. Par rapport à la deuxième simulation, on observe un décalage supplémentaire du premier mode M1 vers les plus petites longueurs d'onde (décalage vers le bleu). L'écart optique OG est ainsi augmenté. On observe en outre une augmentation du facteur de qualité du premier mode M1, c'est-à-dire une diminution de l'étalement du premier mode. On observe en outre une atténuation supplémentaire du deuxième mode M2.

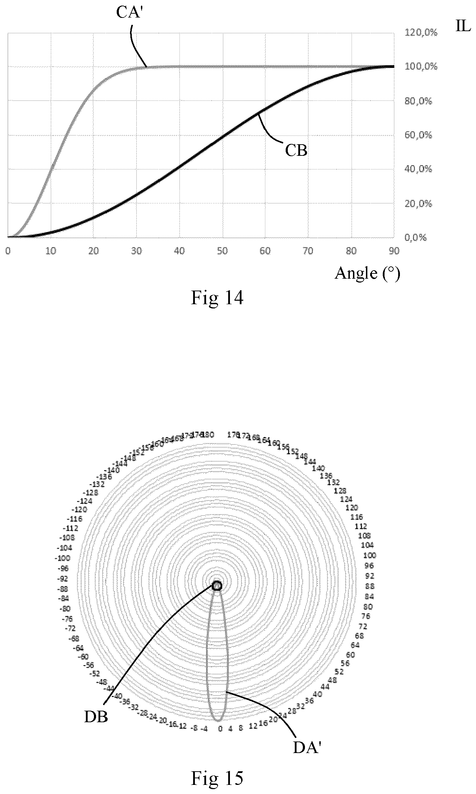

La figure 14 représente une courbe CA' d'évolution du flux cumulé, exprimé en pourcentage, du rayonnement émis par le dispositif optoélectronique 5 selon la présente invention pour la troisième simulation dans un cône d'axe perpendiculaire à la face d'émission 46 en fonction du demi-angle au sommet du cône. La courbe CB correspond à la courbe d'évolution du flux cumulé pour un rayonnement lambertien.

La figure 15 représente un diagramme de rayonnement pour le dispositif optoélectronique 5 selon l'invention lors de la troisième simulation (courbe DA') et pour un rayonnement lambertien (DB). Le diagramme de rayonnement DA' présente sensiblement un seul lobe centré sur 0 °. Il n'y a sensiblement pas de lobes secondaires.

Comme cela apparaît sur les figures 14 et 15, l'essentiel de l'énergie du rayonnement du dispositif optoélectronique 5 selon l'invention est présent dans le lobe unique DA'. En particulier, plus de 80 % du flux du rayonnement est émis dans le cône de demi-angle au sommet égal à 20 °.

Des essais ont été réalisés. Pour le premier essai, un dispositif optoélectronique ayant les caractéristiques de la première simulation a été fabriqué.

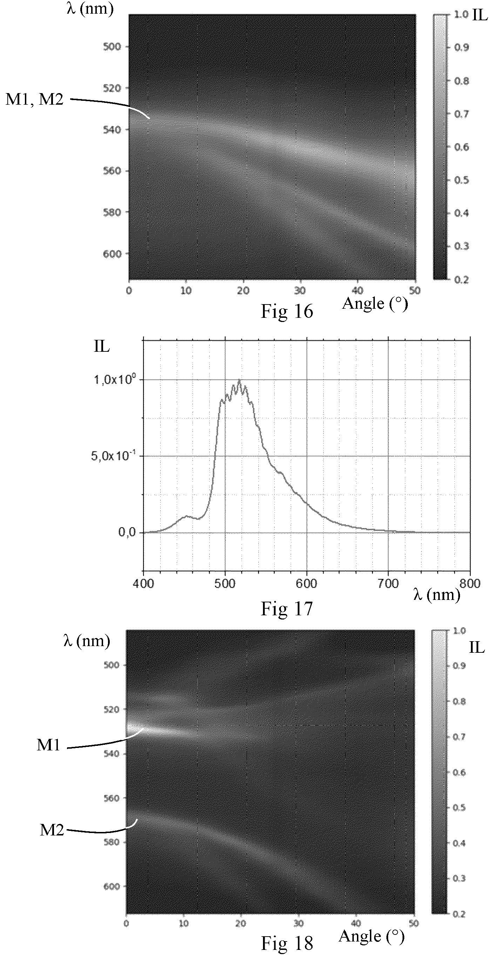

La figure 16 est une carte en niveaux de gris de l'intensité lumineuse IL normalisée du rayonnement émis par la face d'émission 46 du dispositif optoélectronique 5' du premier essai en fonction de la longueur d'onde λ du rayonnement émis et de l'angle d'émission par rapport à une direction orthogonale à la face d'émission 46.

La figure 17 est une courbe d'évolution, de l'intensité lumineuse IL du rayonnement émis par la face d'émission 46, selon une direction orthogonale à la face d'émission, du dispositif optoélectronique 5' du premier essai en fonction de la longueur d'onde X.

Par rapport aux résultats de la première simulation, on observe qu'aux faibles angles il n'y a sensiblement pas d'écart optique entre le premier mode et le deuxième mode. Ceci peut être dû au fait qu'il peut être difficile de former un fil 26 parfaitement cylindrique et que l'on peut observer un léger élargissement du fil 26 au sommet alors que les conditions de croissance devraient conduire à un fil 26 cylindrique.

Pour les deuxième et troisième essais, un dispositif optoélectronique 5 selon l'invention ayant les caractéristiques de la troisième simulation a été fabriqué. Les deuxième et troisième essais différent par les réacteurs utilisés lors de la fabrication des dispositifs optoélectroniques.

La figure 18 est une carte en niveaux de gris de l'intensité lumineuse IL du rayonnement émis par la face d'émission 46 du dispositif optoélectronique 5 du deuxième essai en fonction de la longueur d'onde λ du rayonnement émis et de l'angle d'émission par rapport à une direction orthogonale à la face d'émission 46. Par rapport au premier essai, on observe, comme cela est prévu par les simulations, une augmentation de l'écart optique OG entre le premier mode et le deuxième mode.

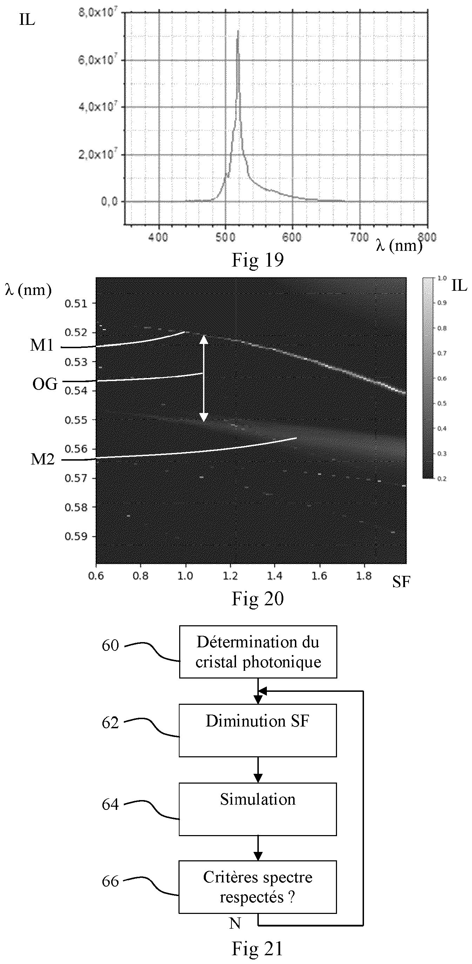

La figure 19 est une courbe d'évolution, de l'intensité lumineuse IL du rayonnement émis par la face d'émission 46, selon une direction orthogonale à la face d'émission, du dispositif optoélectronique 5 du troisième essai en fonction de la longueur d'onde X. On observe un rétrécissement du pic d'émission du premier mode par rapport à la figure 17, le deuxième mode n'étant pas présent.

La figure 20 est une carte en niveaux de gris, obtenue par simulation, de l'intensité lumineuse émise par le dispositif optoélectronique 5 selon l'invention de la figure 1 en fonction de la longueur d'onde X du rayonnement émis et du rapport d'amincissement SF, pour un angle d'émission par rapport à une direction orthogonale à la face d'émission 46 sensiblement égal à 0 °. On remarque bien que, lorsque le rapport d'amincissement SF diminue, le deuxième mode M2 tend à disparaître, le premier mode M1 se décale vers les plus petites longueurs, et l'écart optique (OG) augmente. Pour SF inférieur ou égal à 1,2, le deuxième mode M2 devient négligeable. La figure 20 donne l'impression que le premier mode M1 disparaît lorsque le rapport d'amincissement SF diminue. En réalité, le premier mode M1 s'affine lorsque le rapport d'amincissement SF diminue, ce qui signifie que le facteur de qualité du premier mode M1 augmente lorsque le rapport d'amincissement SF diminue.

La figure 21 est un schéma par blocs d'un mode de réalisation d'un procédé de conception selon la présente invention d'un dispositif optoélectronique également selon l'invention.

A l'étape 60, il est déterminé les caractéristiques du cristal photonique permettant d'obtenir des premières propriétés souhaitées pour le spectre d'émission. Les caractéristiques du cristal photonique peuvent comprendre le pas a de la matrice de diodes électroluminescentes et le diamètre D_{nw} des fils 26. Les premières propriétés souhaitées pour le spectre d'émission peuvent comprendre la longueur d'onde principale souhaitée du pic d'émission. Selon un mode de réalisation, la détermination des caractéristiques du cristal photonique peut comprendre la réalisation successive de simulations par ordinateur, chaque simulation étant réalisée en considérant des diodes électroluminescentes avec un rapport d'amincissement SF égal à 2. A titre d'exemple, une simulation est réalisée avec des valeurs initiales pour le pas a et le diamètre moyen D_{nw}, et ces valeurs sont modifiées en fonction d'un critère donné, par exemple la différence entre la longueur d'onde principale du pic de résonance de la simulation par rapport à la longueur d'onde principale souhaitée, cette opération étant répétée jusqu'à l'obtention du spectre d'émission ayant les propriétés souhaitées. Le procédé se poursuit à l'étape 62.

A l'étape 62, le rapport d'amincissement SF est diminué. Le procédé se poursuit à l'étape 64.

A l'étape 64, une simulation du fonctionnement du dispositif optoélectronique avec le nouveau rapport d'amincissement SF est réalisée. Le procédé se poursuit à l'étape 66.

A l'étape 66, il est déterminé si le procédé peut être terminé. Selon un mode de réalisation, il est déterminé si des deuxièmes propriétés souhaitées du rayonnement d'émission sont atteintes. Les deuxièmes propriétés souhaitées peuvent comprendre la largeur de bande du spectre d'émission et/ou la directivité du rayonnement émis, par exemple par l'absence de lobes secondaires dans le diagramme de rayonnement. Si les deuxièmes propriétés du rayonnement émis sont atteintes, le procédé est terminé. Dans le cas contraire, le procédé se poursuit à l'étape 62 à laquelle une nouvelle diminution du rapport d'amincissement SF est réalisée.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. Enfin, la mise en oeuvre pratique des modes de réalisation et variantes décrits est à la portée de la personne du métier à partir des indications fonctionnelles données ci-dessus. L'objet de la protection conférée est défini par les revendications qui suivent.

## Revendications

1. Dispositif optoélectronique (5) comprenant une matrice de diodes électroluminescentes axiales (LED), chaque diode électroluminescente comprenant une couche active (36) configurée pour émettre un rayonnement électromagnétique, la matrice formant un cristal photonique configuré pour former, dans un plan contenant les couches actives, au moins des premiers et deuxièmes pics de résonance, chaque premier pic de résonance amplifiant l'intensité dudit rayonnement électromagnétique à une première longueur d'onde, chaque deuxième pic de résonance amplifiant l'intensité dudit rayonnement électromagnétique à une deuxième longueur d'onde, dans lequel chaque diode électroluminescente (LED) comprend un élément semiconducteur allongé (26) selon un axe (Δ), ayant une première portion (28) ayant un premier diamètre moyen (D_{nw}), une deuxième portion (30) prolongeant la première portion et ayant une section droite diminuant en s'éloignant de la première portion, et la couche active (36) prolongeant la deuxième portion et ayant un deuxième diamètre moyen (Dₜₒₚ) inférieur strictement au premier diamètre moyen, les couches actives étant situées aux emplacements des premiers pics de résonance et absentes aux emplacements des deuxièmes pics de résonance.

2. Dispositif selon la revendication 1, dans lequel le double du rapport entre le deuxième diamètre moyen (Dₜₒₚ) et le premier diamètre moyen (D_{nw}), est compris entre 0,5 et 1,8.

3. Dispositif selon la revendication 2, dans lequel le double du rapport entre le deuxième diamètre moyen (Dₜₒₚ) et le premier diamètre moyen (D_{nw}), est compris entre 0,6 et 1,4.

4. Dispositif selon l'une quelconque des revendications 1 à 3, dans lequel le premier diamètre moyen (D_{nw}), est compris entre 0,05 µm et 2 µm.

5. Dispositif selon la revendication 4, dans lequel le premier diamètre moyen (D_{nw}), est compris entre 100 nm et 1 µm.

6. Dispositif selon l'une quelconque des revendications 1 à 5, dans lequel la hauteur (Hₜₒₚ), mesurée selon ledit axe (Δ), de la deuxième portion (30) est inférieure à 10 % de la hauteur, mesurée selon ledit axe de l'élément semiconducteur allongé.

7. Dispositif selon l'une quelconque des revendications 1 à 6, dans lequel la première portion (28) de l'élément semiconducteur allongé (26) a une section droite constante.

8. Dispositif selon l'une quelconque des revendications 1 à 7, dans lequel les diodes électroluminescentes axiales (LED) sont agencées en réseau avec un pas (a) compris entre 0,1 µm et 4 µm.

9. Dispositif selon l'une quelconque des revendications 1 à 8, dans lequel la hauteur de chaque élément semiconducteur allongé (26), mesurée selon ledit axe (Δ), est comprise entre 100 nm et 50 µm.

10. Procédé de conception du dispositif optoélectronique (5) selon l'une quelconque des revendications 1 à 9, comprenant les étapes suivantes :
a) déterminer (60) par simulation le pas (a) du cristal photonique et le premier diamètre moyen (D_{nw}), en considérant que les éléments semiconducteurs allongés (26) sont à section droite constante ;
b) diminuer (62) le deuxième diamètre moyen (Dₜₒₚ) sans modifier le premier diamètre moyen ;
c) simuler (64) le fonctionnement du dispositif optoélectronique (5) avec les couches actives ayant le deuxième diamètre moyen diminué ; et
d) répéter les étapes b) et c) jusqu'à ce que les couches actives soient situées aux emplacements des premiers pics de résonance et absentes aux emplacements des deuxièmes pics de résonance.

## Patentansprüche

1. Optoelektronische Vorrichtung (5), die eine Matrix aus axialen Leuchtdioden (LED) aufweist, wobei jede Leuchtdiode eine aktive Schicht (36) aufweist, die konfiguriert ist zum Emittieren einer elektromagnetischen Strahlung, wobei die Matrix einen photonischen Kristall bildet, der konfiguriert ist zum Bilden mindestens eines ersten und eines zweiten Resonanzpeaks in einer Ebene, die die aktiven Schichten enthält, wobei jede erste Resonanzspitze die Intensität der elektromagnetischen Strahlung bei einer ersten Wellenlänge verstärkt und jede zweite Resonanzspitze die Intensität der elektromagnetischen Strahlung bei einer zweiten Wellenlänge verstärkt, wobei jede Leuchtdiode (LED) ein längliches Halbleiterelement (26) entlang einer Achse (Δ) aufweist, mit einem ersten Abschnitt (28) mit einem ersten mittleren Durchmesser (D_{nw}), einem zweiten Abschnitt (30), der den ersten Abschnitt verlängert und eine Querschnittsfläche aufweist, die ausgehend vom ersten Abschnitt her abnimmt, und mit der aktiven Schicht (36), die den zweiten Abschnitt verlängert und mit einem zweiten mittleren Durchmesser (Dₜₒₚ), der streng unter dem ersten mittleren Durchmesser liegt, wobei die aktiven Schichten an den Stellen der ersten Resonanzspitzen angeordnet sind und an den Stellen der zweiten Resonanzspitzen fehlen.

2. Vorrichtung nach Anspruch 1, wobei das doppelte des Verhältnisses des zweiten mittleren Durchmessers (Dₜₒₚ) zum ersten mittleren Durchmesser (D_{nw}), zwischen 0,5 und 1,8 liegt.

3. Vorrichtung nach Anspruch 2, wobei das doppelte des Verhältnisses des zweiten mittleren Durchmessers (Dₜₒₚ) zum ersten mittleren Durchmesser (D_{nw}), zwischen 0,6 und 1,4 liegt.

4. Vorrichtung nach einem der Ansprüche 1 bis 3, wobei der erste mittlere Durchmesser (D_{nw}), zwischen 0,05 µm und 2 µm liegt.

5. Vorrichtung nach Anspruch 4, wobei der erste mittlere Durchmesser (D_{nw}), zwischen 100 nm und 1 µm liegt.

6. Vorrichtung nach einem der Ansprüche 1 bis 5, wobei die Höhe (Hₜₒₚ) des zweiten Abschnitts (30), gemessen entlang der Achse (Δ), weniger als 10% der Höhe des länglichen Halbleiterelements, gemessen entlang der Achse, beträgt.

7. Vorrichtung nach einem der Ansprüche 1 bis 6, wobei der erste Abschnitt des langgestreckten Halbleiterelements (26) einen konstanten Querschnitt aufweist.

8. Vorrichtung nach einem der Ansprüche 1 bis 7, wobei die axialen Leuchtdioden (LED) in einem Array mit einem Abstand (a) zwischen 0,1 µm und 4 µm angeordnet sind.

9. Vorrichtung nach einem der Ansprüche 1 bis 8, wobei die Höhe jedes länglichen Halbleiterelements (26), gemessen entlang der Achse (Δ), zwischen 100 nm und 50 µm liegt.

10. Verfahren zum Entwerfen der optoelektronischen Vorrichtung (5) nach einem der Ansprüche 1 bis 9, das die folgenden Schritte aufweist:
a) Bestimmen des Abstands (a) des photonischen Kristalls und des ersten mittleren Durchmessers (D_{nw}), durch Simulation, wobei davon ausgegangen wird, dass die länglichen Halbleiterelemente (26) einen konstanten Querschnitt aufweisen;
b) Verkleinern des zweiten mittleren Durchmessers (Dₜₒₚ) ohne Änderung des ersten mittleren Durchmessers;
c) Simulieren des Betriebs der optoelektronischen Vorrichtung (5) mit den aktiven Schichten, die den verringerten zweiten mittleren Durchmesser aufweisen; und
d) Wiederholen der Schritte b) und c), bis sich die aktiven Schichten an den Stellen der ersten Resonanzspitzen befinden und an den Stellen der zweiten Resonanzspitzen nicht mehr vorhanden sind.

## Claims

1. An optoelectronic device (5) comprising a matrix of axial light emitting diodes (LED), each light emitting diode comprising an active layer (36) configured to emit electromagnetic radiation, the matrix forming a photonic crystal configured to form at least first and second resonance peaks, in a plane containing the active layers, each first resonance peak amplifying the intensity of said electromagnetic radiation at a first wavelength, each second resonance peak amplifying the intensity of said electromagnetic radiation at a second wavelength wherein each light emitting diode (LED) comprises an elongated semiconductor element (26) along an axis (Δ), having a first portion (28) of a first average diameter (D_{nw}), , a second portion (30) extending the first portion and having a cross-sectional area decreasing away from the first portion and the active layer (36) extending the second portion and having a second average diameter (Dₜₒₚ) strictly less than the first average diameter, the active layers being located at the locations of the first resonance peaks and absent at the locations of the second resonance peaks.

2. The device according to claim 1, wherein twice the ratio of the second average diameter (Dₜₒₚ) to the first average diameter (D_{nw}), is between 0.5 and 1.8.

3. The device according to claim 2, wherein twice the ratio of the second average diameter (Dₜₒₚ) to the first average diameter (D_{nw}), is between 0.6 and 1.4.

4. The device according to any one of claims 1 to 3, wherein the first average diameter (D_{nw}), is between 0.05 µm and 2 µm.

5. The device according to claim 4, wherein the first average diameter (D_{nw}), is between 100 nm and 1 µm.

6. The device according to any one of claims 1 to 5, wherein the height (Hₜₒₚ) of the second portion (30), measured along said axis (Δ), is less than 10% of the height of the elongated semiconductor element, measured along said axis.

7. The device according to any one of claims 1 to 6, wherein the first portion of the elongated semiconductor element (26) has a constant cross-section.

8. The device according to any one of claims 1 to 7, wherein the axial light emitting diodes (LED) are arranged in an array with a pitch (a) of between 0.1 µm and 4 µm.

9. The device according to any one of claims 1 to 8, wherein the height of each elongated semiconductor element (26), measured along said axis (Δ), is between 100 nm and 50 µm.

10. A method for designing the optoelectronic device (5) according to any one of claims 1 to 9, comprising the following steps:
a) determining the pitch (a) of the photonic crystal and the first average diameter (D_{nw}), by simulation, considering that the elongated semiconductor elements (26) have a constant cross-section;
b) decreasing the second average diameter (Dₜₒₚ) without changing the first average diameter;
c) simulating the operation of the optoelectronic device (5) with the active layers having the decreased second average diameter; and
d) repeating steps b) and c) until the active layers are located at the locations of the first resonant peaks and absent at the locations of the second resonant peaks.
